# FASCICULE DE BREVET EUROPEEN

(11) **EP 0 573 607 B1**
(45) Date de publication et mention de la délivrance du brevet: **29.01.2003**
(21) Numéro de dépôt: 92908623.9
(22) Date de dépôt: 28.02.1992
(51) Int. Cl.: G06F 11/20, G09G 3/36

(54) **REGISTRES A DECALAGE REDONDANTS POUR DISPOSITIFS DE BALAYAGE**
Redundante Schieberegister für Abtastungsvorrichtungen
REDUNDANT SHIFT REGISTERS FOR SCANNING DEVICES

(30) Priorité: 28.02.1991 US 660274
(43) Date de publication de la demande: 15.12.1993
(60) Demande divisionnaire: 99123657.1
(73) Titulaire: THALES AVIONICS LCD S.A., 92800 Puteaux (FR)
(72) Inventeur: DUPONT, Antoine, Pierre, F-92045 Paris-La Défense Cédex 67 (FR); PLUS, Dora, F-92045 Paris-La Défense Cédex 67 (FR)
(74) Mandataire: Ruellan-Lemonnier, Brigitte
(86) Numéro de dépôt international: FR9200187
(87) Numéro de publication internationale: WO92015931

(56) Documents cités:
- EP-A- 0 177 247
- EP-A- 0 197 551
- GB-A- 2 135 098
- US-A- 5 063 378

## Description

La présente invention concerne généralement les registres à décalage et en particulier les registres à décalage redondants pour dispositifs de balayage, tels que les afficheurs à cristaux liquides.

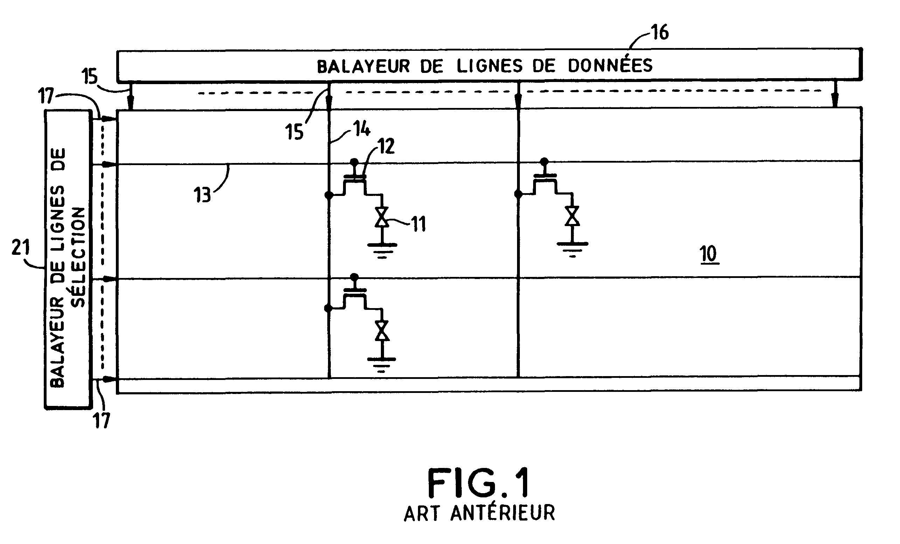

Les afficheurs à cristaux liquides pour la télévision et les ordinateurs sont connus dans la technique. Un afficheur à cristaux liquides simplifié suivant une technique antérieure est représenté sur la Figure 1. L'afficheur inclut une matrice d'éléments à cristal liquide 11 disposés en rangées et colonnes. Chaque élément à cristal liquide est associé avec un dispositif de commutation 12, tel qu'un transistor à couches minces (TFT). La grille de chaque TFT 12 est connectée à une ligne de sélection 13 si bien qu'une rangée entière de TFT est polarisée simultanément par chaque ligne de sélection 13. Les lignes de sélection 13 sont connectées séparément aux bornes de sortie 17 d'un balayeur 18 de ligne de sélection, qui fournit les tensions de polarisation aux lignes de sélection. Le drain de chaque TFT est connecté à une ligne de données 14 qui fournit un signal d'échelle de gris (luminosité) à l'élément à cristal liquide 11 associé au TFT polarisé 12. Les lignes de données 14 sont connectées séparément aux bornes de sortie 15 d'un balayeur 16 de ligne de données.

Le balayeur 18 de ligne de sélection est un registre à décalage avec un étage pour chacune des lignes de sélection 13, et les lignes de sélection 13 sont polarisées séquentiellement par les étages séparés du balayeur. Les signaux de luminosité sont appliqués simultanément à toutes les lignes de données 14 par un balayeur 16 de ligne de données de telle sorte que tous les éléments à cristal liquide 11 associés à la ligne de sélection polarisée sont simultanément chargés aux différentes tensions en fonction des signaux de luminosité reçus du balayeur 16 de lignes de données. Les TFT 12, le balayeur 16 de ligne de données et le balayeur 18 de ligne de sélection sont fabriqués de préférence sur le même substrat, les balayeurs 16 et 18 se trouvant le long du pourtour du substrat.

Les afficheurs à cristaux liquides pour la télévision et les moniteurs d'ordinateurs comportent un grand nombre de colonnes de cellules à cristaux liquides, par exemple 1.440. Un afficheur ayant ce nombre de colonnes et ayant le format d'image standard de 3x4 aurait environ 1.080 lignes de sélection. Un afficheur avec ce nombre de lignes de sélection et de lignes de données comprendrait environ 1,56 million de transistors TFT 12. Le balayeur 18 de ligne de sélection comprendrait 1.080 étages et le balayeur 16 de ligne de données comprendrait 1.440 étages. En raison de ce grand nombre d'éléments, le rendement de fabrication d'afficheurs acceptables tend à être faible. Il y a donc besoin d'un moyen permettant d'augmenter le rendement de ces afficheurs.

Le document GB-A-2135098 de Citizen Watch Company Limited décrit un écran à matrice active utilisant des balayeurs de lignes de sélection redondants divisés en sections permettant de mettre hors-circuit une des sections défectueuses d'un balayeur pour être remplacée par la section correspondante de l'autre balayeur par coupure d'un segment de ligne séparée spécialement prévue qui est inclus dans chaque étage des deux balayeurs redondants.

La présente invention est définie par la revendication 1.

La présente invention peut être utilisée avec l'invention décrite dans WO-A- 92 15 992.

La présente invention peut être utilisée avec l'invention décrite dans US-A- 5 136 662.

Cette demande est en relation avec l'invention décrite dans WO-A- 92 15 892.

La Figure 1 montre d'une manière simplifiée un type d'afficheur à cristaux liquides selon l'art antérieur.

La Figure 2 représente un mode de réalisation préférentiel d'un afficheur (avec la matrice d'éléments à cristal liquide non représentée) incluant une réalisation schématique des étages en cascade des balayeurs de ligne de sélection redondants.

La Figure 3 est un dessin d'un étage d'un balayeur de ligne de sélection qui est disposé selon les techniques utilisées généralement pour la disposition des circuits à semi-conducteurs.

La Figure 4 représente un mode de réalisation préférentiel du dessin d'un étage d'un balayeur de ligne de sélection selon la présente invention.

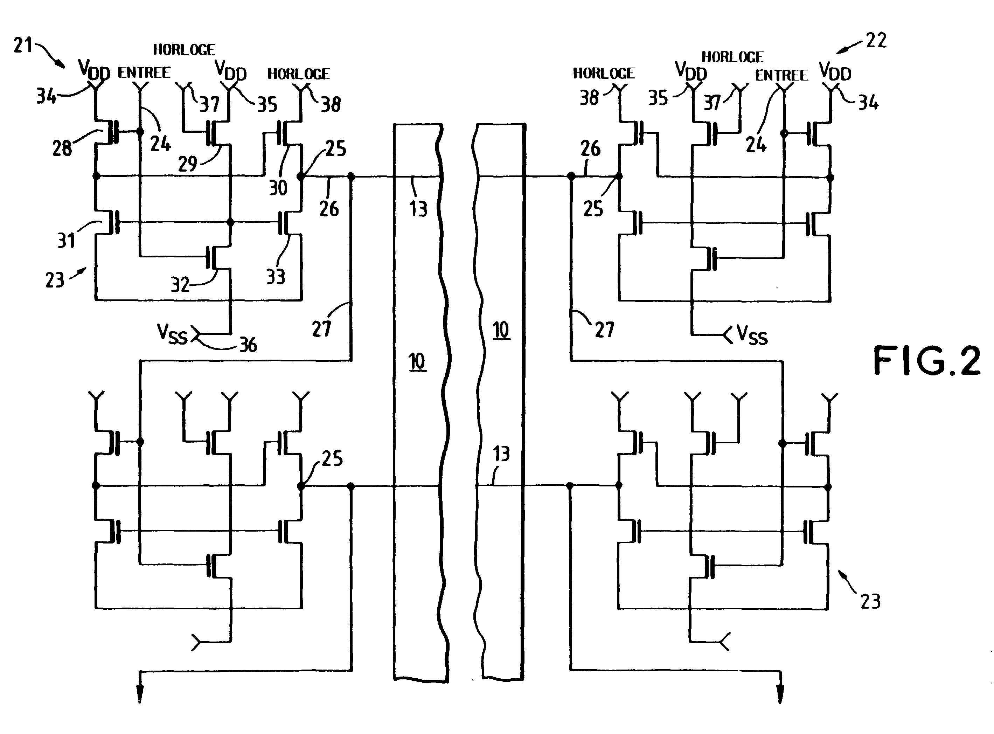

Sur la Figure 2, la matrice des éléments à cristal liquide 10 a été supprimée pour faciliter l'illustration des étages du balayeur de ligne de sélection. Les balayeurs de ligne de sélections redondants 21 et 22 comprennent une pluralité d'étages identiques 23, chacun avec une borne d'entrée 24 et une borne de sortie 25. Chaque étage 23 inclut aussi des bornes de polarisation 34, 35 et 36, des bornes d'horloge 37 et 38. Différentes alimentations électriques et générateurs d'impulsions (non représentés) fournissent les tensions de polarisation et les signaux d'horloge aux registres 21 et 22 de lignes de sélection. Les étages 23 sont décrits en détail dans la demande de brevet en cours S/N 660272 déjà mentionnée ci-dessus. Les étages 23 des balayeurs 21 et 22 de ligne de sélection et les lignes de sélection 13 sont numérotés dans l'ordre et les étages à numéros correspondants des balayeurs 21 et 22 sont couplés aux extrémités opposées des lignes de sélection 13 de numéros correspondants par les segments de ligne séparée 26. Les segments de ligne séparée 26 relient aussi les bornes de sortie 25 des étages respectifs aux bornes d'entrée 24 des étages suivant immédiatement par l'intermédiaire des lignes 27.

En fonctionnement, les balayeurs 21 et 22 de ligne de sélection fonctionnent en synchronisation et la production d'une impulsion de sortie par un étage fournit une impulsion d'entrée à l'étage suivant immédiatement et polarise aussi la ligne de sélection associée 13. Un étage défectueux pour une raison quelconque peut être simplement sorti du système en coupant le segment de ligne séparée 26 de l'étage défectueux et l'étage de numéro correspondant de l'autre balayeur fournit l'impulsion d'entrée à l'étage suivant des deux balayeurs 21 et 22.

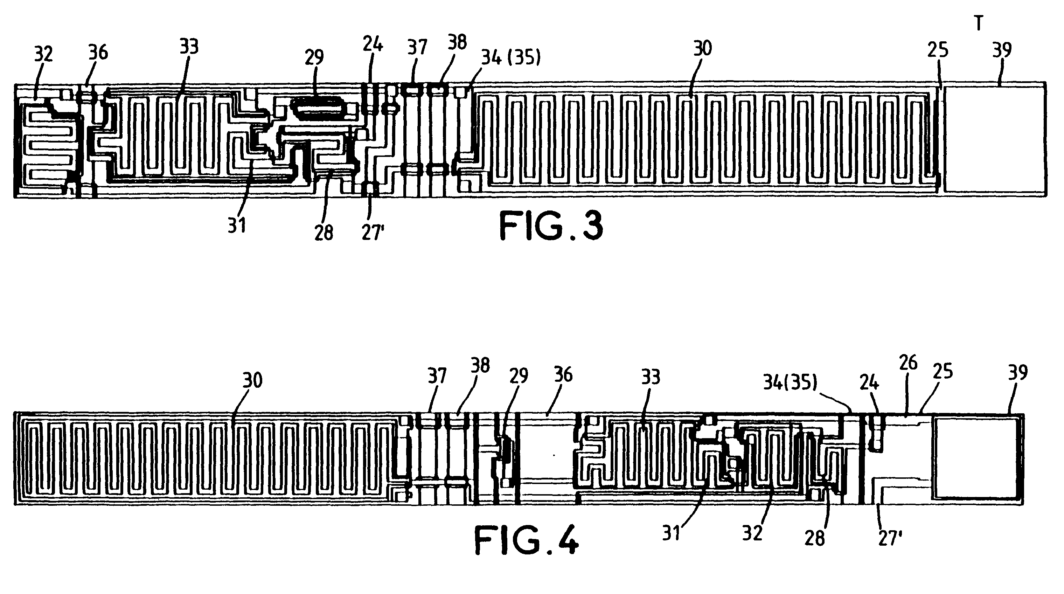

Chaque étage 23 des deux balayeurs 21 et 22 de ligne de sélection est composé de six TFT 28 à 33. Les TFT 28 à 33 sont de préférence fabriqués sur le même substrat que les TFT 12 (Figure 1) et en même temps que la fabrication des TFT 12. La Figure 3 représente un dessin très agrandi des six transistors 28 à 33 dans un des étages 23, qui résulte des techniques de dessin de circuit typiquement utilisés. Généralement, quand on dessine des circuits à semi-conducteurs, les dispositifs d'entrée et la borne d'entrée sont disposés dans une section d'entrée et les dispositifs de sortie sont disposés dans une section sortie près de la borne de sortie 25 ; les bornes d'entrée et de sortie sont donc éloignées l'une de l'autre. Un pavé de test 39 fournit un espace permettant d'installer une sonde de test parce que les lignes du circuit à semi-conducteurs ont une largeur de quelques microns et ne peuvent donc être aisément connectées au matériel de test. Sur la Figure 3, le transistor de sortie 30 est disposé d'un côté des bornes 34, 37 et 38 à proximité de la borne de sortie 25 et du pavé de test 39. Les autres dispositifs à semi-conducteurs 28, 29, 31, 32 et 33 et la borne 36 sont disposés de l'autre côté de la borne 34, 37 et 38. De plus, la borne 27', qui est connectée à la ligne 27 pour appliquer le signal de sortie à la borne d'entrée de l'étage suivant, est disposée directement entre la borne d'entrée 24 et la borne d'horloge 37, les bornes 25 et 27' étant reliées électriquement. Avec le dessin représenté sur la Figure 3, la technique d'isolement des étages défaillants d'un balayeur de lignes de données en coupant un segment de ligne séparée 26 ne peut pas être utilisée parce qu'il n'y a pas de moyen d'avoir un segment de ligne séparée et il n'y a pas de ligne qui puisse être coupée pour atteindre le même but. Ainsi, avec le dessin de la Figure 3, si l'un des étages 23 comporte un défaut quelconque, l'étage défaillant ne peut pas être isolé du balayeur de ligne de sélection, et le dispositif doit être mis au rebut s'il ne peut être réparé.

La Figure 4 est un dessin préférentiel dans lequel le pavé de test 39 est disposé à une extrémité du substrat sur lequel le circuit à semi-conducteurs est fabriqué. La borne d'entrée 24, la borne de sortie 25, le segment de ligne séparée 26 et la borne 27' sont disposés à proximité immédiate du pavé de test 39. Les TFT 28 à 33 sont disposés sur le côté des bornes d'entrée et de sortie opposé au côté du pavé de test 39. Les bornes d'entrée et de sortie 24 et 25 sont donc entre les dispositifs à semi-conducteurs et le pavé de test 39. Avec la configuration de la Figure 4, tout type de défaut, dans tout élément de l'étage, peut être circonvenu parce que l'étage défaillant peut être isolé des autres étages du registre en faisant seulement une coupure dans le segment de ligne séparée 26 de l'étage défaillant à l'aide d'un laser, technologie bien connue dans le métier. La configuration de la Figure 4 est très différente des configurations résultant des techniques de dessin typiques de disposition parce que le dispositif de sortie 30 est éloigné de la borne de sortie 25, et parce que les bornes d'entrée et de sortie sont très proches l'une de l'autre.

L'invention présente plusieurs avantages importants. Un défaut commun dans la fabrication des matrices d'éléments à cristal liquide se situe au niveau des courts-circuits entre les lignes de sélection et les lignes de données, à leurs points de croisement. Grâce à l'invention, le problème de ces courts-circuits peut être corrigé en coupant simplement la ligne de sélection en court-circuit des deux côtés du court-circuit. La ligne de données reste passante sur toute sa longueur, et les deux parties de la ligne de sélection sont polarisées par les étages respectifs du registre avec lesquels elles sont associées.

Un autre problème de fabrication est celui des coupures dans les lignes de sélection. Avec l'invention, ce problème est réduit d'une manière importante parce qu'une seule coupure dans une ligne de sélection particulière ne rend pas la ligne non passante, les deux parties de la ligne coupée sont polarisées par les étages respectifs du registre avec lesquels elles sont associées et toutes les cellules à cristaux liquides connectées à la ligne coupée reçoivent une tension de polarisation.

Il est possible qu'un court-circuit ait lieu dans la section entrée d'un étage et mette en court-circuit la borne d'horloge avec la borne d'entrée. Cette situation peut être nuisible à l'étage précédent même après la coupure du segment de ligne séparée 26. Grâce à la disposition suivant l'invention, cet inconvénient est corrigé par la coupure du segment de ligne séparée 26 de l'étage défaillant, et la borne 27' de l'étage précédent, l'étage défaillant étant alors complètement isolé des deux registres.

## Revendications

1. Un dispositif d'affichage comportant une matrice d'éléments d'affichage (10) disposés en rangées et en colonnes, des moyens (16) pour appliquer des signaux de données auxdites colonnes (15) d'éléments, et une pluralité de lignes (13) de sélection pour polariser lesdites rangées d'éléments, ledit dispositif d'affichage comprenant :
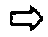 des balayeurs (21, 22) redondants de ligne de sélection pour sélectionner séquentiellement les lignes de sélection (13), chaque balayeur (21 ou 22) comprenant une pluralité d'étages (23) numérotés dans l'ordre, ayant chacun une borne d'entrée (24) et une borne de sortie (25), la borne d'entrée (24) de chaque étage (23) étant connectée à la borne de sortie (25) de l'étage (23) immédiatement précédent, **caractérisé en ce que** les balayeurs (21, 22) fonctionnent en synchronisme, et
qu'il comporte de plus des segments de ligne séparés (26) connectant les bornes de sortie (25) de chaque étage (23) numéroté de manière correspondante des balayeurs (21, 22) aux extrémités opposées des lignes de sélection (13) numérotées en correspondance et aux bornes d'entrée (24) des étages (23) suivant immédiatement, de sorte que chaque étage (23) d'un balayeur (21) est isolable de l'étage (23) de numéro correspondant de l'autre balayeur (22) en coupant le segment de ligne séparée (26) associé avec l'étage défaillant (23).

2. Dispositif selon la revendication 1, **caractérisé en ce que** les balayeurs de lignes de sélection (21, 22) sont disposés sur des côtés opposés du dispositif d'affichage.

3. Dispositif selon les revendications 1 ou 2, **caractérisé en ce que** la borne d'entrée (24) et la borne de sortie (25) d'un étage (23) sont positionnées sur la même partie de substrat sur lequel est réalisé ledit étage.

4. Dispositif selon l'une quelconque des revendications 1 à 3, **caractérisé en ce que** la coupure du segment de ligne est une coupure mécanique telle qu'une coupure laser.

## Patentansprüche

1. Wiedergabevorrichtung mit einer Matrix von Wiedergabelementen (10), die in Reihen und in Spalten angeordnet sind, mit Mitteln (16) zum Zuführen von Datensignalen zu den Spalten (15) der Elemente und einer Vielzahl von Auswahlleitungen (13) für eine Vorspannung der Reihen der Elemente mit:
redundanten Abtasteinheiten (21, 22) für die Auswahlleitung zum sequentiellen Wählen der Auswahlleitungen (13), wobei jede Abtasteinheit (21 oder 22) eine Vielzahl von durchgehend numerierten Stufen (23) enthält und jede eine Eingangsklemme (24) und eine Ausgangsklemme (25) enthält, und die Eingangsklemme (24) jeder Stufe (23) mit der Ausgangsklemme (25) der unmittelbar vorangehenden Stufe (23) verbunden ist,
**dadurch gekennzeichnet, daß**
die Abtasteinheiten (21, 22) synchron arbeiten und daß sie außerdem getrennte Leitungssegmente (26) enthalten, die die Ausgangsklemmen (25) jeder Stufe (23), die in entsprechender Wiese wie die Abtasteinheiten (21, 22) numeriert ist, mit den gegenüberliegenden Enden entsprechend numerierter Auswahlleitungen (13) und mit den Eingangsklemmen (24) der unmittelbar darauffolgenden Stufen (23) derart verbinden, daß jede Stufe (23) einer Abtasteinheit (21) von der Stufe (23) mit der entsprechenden Nummer der anderen Abtasteinheit (22) isoliert ist, indem das Segment der getrennten Leitung (26), das zu der fehlerhaften Stufe (23) gehört, aufgeschnitten wird.

2. Vorrichtung nach Anspruch 1, **dadurch gekennzeichnet, daß** die Abtasteinheiten für die Auswahlleitungen (21, 22) an den gegenüberliegenden Seiten der Wiedergabevorrichtung angeordnet sind.

3. Vorrichtung nach Anspruch 1 oder 2, **dadurch gekennzeichnet, daß** die Eingangsklemme (24) und die Ausgangsklemme (25) einer Stufe (23) auf dem selben Teil des Substrats liegen, auf dem die Stufe ausgebildet ist.

4. Vorrichtung nach einem der Ansprüche 1 bis 3, **dadurch gekennzeichnet, daß** der Aufschneidvorgang des Leitungssegmentes ein mechanischer Aufschneidvorgang wie mit einem Laserstrahl ist.

## Claims

1. A display device having an array of display elements (10) arranged in rows and columns, means (16) for applying data signals to said columns (15) of elements, and a plurality of select lines (13) for voltage biasing said rows of elements, said display device comprising:
redundant select line scanners (21,22) for sequentially selecting said select lines (13), each of said scanners (21 or 22) including a plurality of ordinally numbered stages (23) having an input terminal (24) and an output terminal (25), the input terminal (24) of each stage (23) being connected to the output terminal (25) of the immediately preceding stage (23), **characterized in that** the scanners (21,22) operate in synchronism and it further comprises separate line segments (26) connecting the output terminals (25) of each correspondingly numbered stage (23) of said scanners (21,22) to opposite ends of correspondingly numbered select lines 13 and to input terminal (24) of immediately following stages (23), whereby each stage (23) of one scanner (21) can be cut off from the correspondingly numbered stage (23) of the other scanner (22) by opening the separate line segment (26) associated with the failed stage (23).

2. Device according to claim 1 **characterized in that** said select line scanners (21,22) are arranged on opposite sides of said display device.

3. Device according to claims 1 or 2, **characterized in that** said input terminal (24) and said output terminal (25) of a stage (23) are arranged on the same part of the substrate on which is manufactured the stage.

4. Device according to anyone of claims 1 to 3, **characterized in that** the opening of the line segment is a mechanical opening such as a laser opening.
